(19) Europäisches Patentamt
European Patent Office
Office européen des brevets

(11) Veröffentlichungsnummer : **0 291 702 B1**

# (12) EUROPÄISCHE PATENTSCHRIFT

(45) Veröffentlichungstag der Patentschrift : **06.03.91 Patentblatt 91/10**

(51) Int. Cl.[5] : **C23C 28/02,** C25D 5/12

(21) Anmeldenummer : **88106163.4**

(22) Anmeldetag : **19.04.88**

## (54) Verfahren zur Herstellung von Verschleissschutzschichten auf Oberflächen von Bauteilen aus Titan oder Titanbasislegierungen.

(30) Priorität : **20.05.87 DE 3716937**

(43) Veröffentlichungstag der Anmeldung : **23.11.88 Patentblatt 88/47**

(45) Bekanntmachung des Hinweises auf die Patenterteilung : **06.03.91 Patentblatt 91/10**

(84) Benannte Vertragsstaaten : **AT CH FR GB IT LI SE**

(56) Entgegenhaltungen : **DD-A- 244 574**

(56) Entgegenhaltungen :
**DE-A- 3 443 329**
**DE-A- 3 708 869**
**DE-C- 3 716 937**
**PATENT ABSTRACTS OF JAPAN, unexamined applications, Field C, Vol. 7, No. 195, 25. August 1983 THE PATENT OFFICE JAPANESE GOVERNMENT Seite 113 C 183**

(73) Patentinhaber : **MTU MOTOREN- UND TURBINEN-UNION MÜNCHEN GMBH**
**Dachauer Strasse 665 Postfach 50 06 40**
**W-8000 München 50 (DE)**

(72) Erfinder : **Thoma, Martin, Dr.**
**Giselastrasse 3**
**W-8000 München 40 (DE)**

**EP 0 291 702 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Herstellung von Verschleißschutzschichten auf Oberflächen von Bauteilen aus Titan oder Titanbasislegierungen. Titanlegierungen werden in Gasturbinentriebwerken aber auch sonst in Bauteilen der Luft- und Raumfahrt wie Landeklappenführungen, Ventilgehäusen, Kompaßgehäusen, Laufrädern von Pumpen etc. angewandt.

Da Titanlegierungen sehr verschleißempfindlich sind, ist eine Verschleißschutzbeschichtung in vielen Fällen erforderlich. Ein bekanntes Verfahren zur Herstellung von Verschleißschutzschichten der bestehenden Art ist in der DE-PS 33 21 231 der Anmelderin beschrieben.

Aufgabe der Erfindung ist es, dieses bekannte Verfahren zur Herstellung von Verschleißschutzschichten in der Hinsicht zu verbessern, daß ihm ein noch breiterer Anwendungsbereich bei der Beschichtung von Bauteilen aus Titan oder Titanlegierungen zukommt.

Die Lösung der Aufgabe erfolgt mit den Merkmalen des Anspruches 1. Es sind auch Verbundwerkstoffe mit Titan so zu beschichten.

Der wesentlichste Vorteil des erfindungsgemäßen Verfahrens besteht darin, daß haftfestes Verchromen von Titan- und Titanlegierungsbauteilen ermöglicht wird, was nach bisherigem Kenntnisstand nicht zu erwarten war und deren Anwendungsmöglichkeiten verbreitert sind : u.a., für Strukturbauteile, Gehäuseteile, Verkleidungen, Radome, Verdichterbeschaufelung (Rotor und Stator), Bläser (Fan-) Schaufeln, Profpans.

Ausführungsbeispiel : Die haftfeste Verchromung von Oberflächen von Bauteilen aus Ti oder Ti-Basislegierungen ist auf folgendem Wege möglich :

– Stromlos vernickeln von Oberflächen nach Patent 33 21 231
– Wärmebehandlung bei mindestens 450°C zur Erzeugung von Ti-Ni-Diffusionsschichten $TiNi_3$ und $Ti_2Ni$ (nach Patent 33 21 231) ca. $16^h$ in Luft.
– Entfernen von überschüssigem Ni mit Nitroaromat/Cyanidlösung (oder $HNO_3$)
– Verchromen der Titanlegierungen auf ausgebildeter $Ti_2Ni$-Schicht (und/oder) $TiNi_3$-Schicht (Diffusionsschicht).

Badtyp : beim galvanischen Verchromen übliche $CrO_3$-Bäder

| | | |
|---|---|---|
| z.B. | $CrO_3$ | 250g/l |
| | $H_2SO_3$ | 1,6g/l |
| | $H_2SiF_6$ | 4g/l |

zur galvanischen Abscheidung bei 55°C und 20 bis 80 A/dm², oder
265 g/l $CrO_3$ und
1 Gew.% $H_2SO_4$ bezogen auf $CrO_3$
zur galvanischen Abscheidung bei 50°C und 20 bis 80 A/dm².

Abwandlungen dieser Gehalte von ± 10% sind ohne Nachteil : die Badtemperaturen können zwischen Raumtemperatur und 80°C gewählt werden.

## Ansprüche

1. Verfahren zur Herstellung von Verschleißschutzschichten auf Oberflächen von Bauteilen aus Titan- oder Titanlegierungen, durch Aufbringen einer auf der Bauteiloberfläche haftenden Nickelschicht durch chemisches Abscheiden und anschließende Wärmebehandlung zur Erzeugung von Diffusionsschichten und nachfolgendem Entfernen noch vorhandenen Nickels, dadurch gekennzeichnet, daß auf der Titannickeldiffusionsschicht galvanisch aus einem $CrO_3$-Bad eine Chromschicht abgeschieden wird.

2. Verfahren nach Anspruch 1, dadurch gekennzeichnet, daß die Wärmebehandlung zur Erzeugung von Titannickeldiffusionsschichten wie Ti2Ni und TiNi3 bei einer Temperatur von mindestens 450°C für eine Zeitdauer von ca. 16 h in einer Atmosphäre, die sauerstoffhaltig ist, durchgeführt wird.

3. Verfahren nach Anspruch 1, dadurch gekennzeichnet, daß ein galvanisches Bad, das $CrO_3$, $H_2SiF_6$, $H_2SO_4$ enthält, eingesetzt wird.

4. Verahren nach einem der vorhergehenden Ansprüche, dadurch gekennzeichnet, daß die Abscheidung im galvanischen Bad bei einer Stromdichte von 20 bis 80 A/dm² durchgeführt wird.

5. Verfahren nach einem der vorhergehenden Ansprüche, dadurch gekennzeichnet, daß aus einem galvanischen Bad, das

250g/l $CrO_3$,
1,6 g/l $H_2SO_4$
4g/l $H_2SiF_6$

enthält, bei 55°C und 20 bis 80 A/dm² abgeschieden wird.

6. Verfahren nach einem der vorhergehenden Ansprüche, dadurch gekennzeichnet, daß aus einem galvanischen Bad, das 265g/l $CrO_3$ und 1 Gew.% $H_2SO_4$ (bezogen auf $CrO_3$) enthält, bei 50°C und 20 bis 80 A/dm² abgeschieden wird.

## Claims

1. Process for the production of protection layers against wear on surfaces of component parts of titanium or titanium alloys, by applying a nickel layer, which adheres to the component part surface, by chemical deposition and subsequent heat treatment, to produce diffusion layers and subsequent removal of nickel still present, characterised in that on the titanium nickel diffusion layer a chromium layer is galvanically deposited from a $CrO_3$ bath.

2. Process according to claim 1, characterised in that the heat treatment is carried out to produce titanium nickel diffusion layers such as $Ti_2Ni$ and $TiNi_3$ at a temperature of at least 450°C for a period of about 16 hours in an oxygen-containing atmosphere.

3. Process according to claim 1, characterised in that a galvanic bath containing $CrO_3$, $H_2SiF_6$, $H_2SO_4$ is used.

4. Process according to one of the preceding claims, characterised in that deposition is carried out in a galvanic bath at a current density of 20 to 80 A/dm².

5. Process according to one of the preceding claims, characterised in that deposition is carried out from a galvanic bath containing

250g/l $CrO_3$,
1.6g/l $H_2SO_4$
4g/l $H_2SiF_6$

at 55°C and 20 to 80 A/dm².

6. Process according to one of the preceding claims, characterised in that deposition is carried out from a galvanic bath containing 265g/l $CrO_3$ and 1% by weight $H_2SO_4$ (based on $CrO_3$), at 50°C and 20 to 80 A/dm².

## Revendications

1. Procédé de fabrication de couches protectrices contre l'usure sur des surfaces de pièces en titane ou en des alliages de titane, par application par dépôt chimique d'une couche de nickel qui adhère à la surface de la pièce, puis traitement thermique pour produire des couches de diffusion et enlèvement subséquent du nickel encore présent, procédé caractérisé en ce qu'on effectue, sur la couche de diffusion de nickel dans le titane, un dépôt galvanique d'une couche de chrome à partir d'un bain de $CrO_3$.

2. Procédé selon la revendication 1, caractérisé en ce qu'on conduit le traitement thermique pour produire des couches de diffusion de nickel dans le titane, comme $Ti_2Ni$ et $TiNi_3$, à une température d'au moins 450°C pendant une durée d'environ 16 h dans une atmosphère contenant de l'oxygène.

3. Procédé selon la revendication 1, caractérisé en ce qu'on utilise un bain galvanique contenant $CrO_3$, $H_2SiF_6$ et $H_2SO_4$.

4. Procédé selon l'une des revendications précédentes, caractérisé en ce qu'on conduit le dépôt dans un bain galvanique à une densité de courant de 20 à 80 A/dm².

5. Procédé selon l'une des revendications précédentes, caractérisé en ce que le dépôt est effectué est à 55°C et avec 20 à 80 A/dm² à partir d'un bain galvanique contenant :

250 g/l de $CrO_3$,
1,6 g/l de $H_2OSO_4$
4 g/l de $H_2SiF_6$.

6. Procédé selon l'une des revendications précédentes, caractérisé en ce que le dépôt est effectué à 50°C et avec 20 à 80 A/dm² à partir d'un bain galvanique contenant 265 g/l de $CrO_3$ et 1% en poids de $H_2SO_4$ (par rapport à $CrO_3$).